(19) Europäisches Patentamt / European Patent Office / Office européen des brevets

(11) **EP 4 583 404 B1**

(12) **EUROPEAN PATENT SPECIFICATION**

(45) Date of publication and mention
of the grant of the patent:
**22.04.2026 Bulletin 2026/17**

(51) International Patent Classification (IPC):
**H03K 5/08** *(2006.01)* **G06F 13/42** *(2006.01)*
**H03K 19/0175** *(2006.01)*

(21) Application number: **24218805.0**

(22) Date of filing: **10.12.2024**

(52) Cooperative Patent Classification (CPC):
**H03K 5/082; G06F 13/4282; H03K 19/017581**

(54) **I2C INTERFACE CIRCUIT, CORRESPONDING ELECTRONIC DEVICE AND METHOD OF OPERATION**

I2C-SCHNITTSTELLENSCHALTUNG, ZUGEHÖRIGE ELEKTRONISCHE VORRICHTUNG UND BETRIEBSVERFAHREN

CIRCUIT D'INTERFACE I2C, DISPOSITIF ÉLECTRONIQUE CORRESPONDANT ET PROCÉDÉ DE FONCTIONNEMENT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **05.01.2024 IT 202400000123**

(43) Date of publication of application:
**09.07.2025 Bulletin 2025/28**

(73) Proprietor: **STMicroelectronics International N.V.**
**1228 Plan-les-Ouates, Geneva (CH)**

(72) Inventors:
• **MASTRI, Valentina**
**I-20123 Milano (IT)**

• **RAIMONDI, Marco**
**I-20038 Busto Garolfo (Milano) (IT)**
• **BOTTI, Edoardo**
**I-29029 Vigevano (Pavia) (IT)**
• **CACCIAGRANO, Paolo**
**I-21050 Cairate (Varese) (IT)**

(74) Representative: **Buzzi, Notaro & Antonielli d'Oulx S.p.A.**
**Corso Vittorio Emanuele II, 6**
**10123 Torino (IT)**

(56) References cited:
**CN-A- 106 844 270    CN-A- 112 650 377**
**CN-U- 209 765 366    US-A1- 2013 127 512**

**Description**

<u>Technical field</u>

The description relates to electronic circuits (e.g., switching converters) provided with an I²C (Inter-Integrated Circuit) interface.

Switching converters with embedded I²C interface may be implemented, for instance, in class-D power amplifiers (audio amplifiers) used in car radio apparatuses.

<u>Technological background</u>

Switching devices such as class-D amplifiers and switching converters produce electronic noise that can propagate to the digital interfaces of the device itself and thus affect the proper operation of such interfaces. Typically, the higher are the PWM switching frequency, the current and the voltage of the switching device, the higher is the associated electronic noise.

A digital interface that can be affected by noise is the I²C interface (see, as a reference, the User manual UM10204 by NXP, "I2C-bus specification and user manual", Rev. 7.0, 1 October 2021, available online at https://www.nxp.com/docs/en/user-guide/UM10204.pdf). The input comparators of an I²C interface, which are designed to discern between the high level and the low level of an input digital signal, are thus usually designed to have large hysteresis so as to be robust against noise (i.e., avoid spurious commutations due to noise). In this respect, the I²C specification defines an (external) pull-up voltage $V_{pu}$, and defines as well the high-level digital input logic voltage threshold $V_{IH}$ and the low-level digital input logic voltage threshold $V_{IL}$ of the input comparators according to the following constraints: $V_{IH} < 0.7*V_{pu}$ and $V_{IL} > 0.3*V_{pu}$.

At the same time, it is desirable that the input comparators of the I²C interface are compatible with at least two values of the pull-up voltage $V_{pu}$, such as 1.8 V and 3.3 V (which are conventional values of the supply voltage in CMOS technology).

The requirements of large hysteresis on one hand, and compatibility with at least two different pull-up voltage levels on the other hand, are in conflict. In fact, considering an example where compatibility with both $V_{pu18} = 1.8$ V and $V_{pu33} = 3.3$ V is desired at the same time, the values of the comparator thresholds $V_{IH}$ and $V_{IL}$ would be constrained by the following values:

$$V_{IH} < 0.7*V_{pu18} = 0.7*1.8 \text{ V} = 1.26 \text{ V}$$

$$V_{IL} > 0.3*V_{pu33} = 0.3*3.3 \text{ V} = 0.99 \text{ V}$$

The maximum difference $V_{IH}-V_{IL} = 0.27$ V between the high threshold and the low threshold is not sufficient for accommodating possible threshold mismatch, process variations and parasitic voltage drops while still providing sufficient hysteresis for noise rejection.

A known solution to the issue discussed above is that of using a pin of the electronic device for receiving the external pull-up voltage $V_{pu}$. By receiving the pull-up voltage in the electronic device, the high threshold $V_{IH}$ and the low threshold $V_{IL}$ for the input comparators of the I²C interface can be generated within the device, and a wider range for hysteresis can be achieved. For instance, considering again an example where compatibility with both $V_{pu18} = 1.8$ V and $V_{pu33} = 3.3$ V is desired, the thresholds $V_{IH}$ and $V_{IL}$ could be generated as follows: if $V_{pu} = 3.3$ V, then $V_{IL} = 0.99$ V and $V_{IH} = 2.31$ V; if $V_{pu} = 1.8$ V, then $V_{IL} = 0.54$ V and $V_{IH} = 1.26$ V. Therefore, if $V_{pu} = 3.3$ V the difference between the thresholds (to be used for hysteresis and accommodating mismatches) would be equal to 1.32 V, while if $V_{pu} = 1.8$ V the difference would be equal to 0.72 V. Such a solution is known, for instance, from the datasheet of device TAS2764 by Texas Instruments, "TAS2764 Digital Input Mono Class-D Audio Amplifier With Speaker IV Sense", SLOS998A, December 2020, Revised September 2021, available online at https://www.ti.com/lit/ds/symlink/tas2764.pdf?ts=170073 8116569&ref_url=https% 253A%252F%252Fwww.ti.com%252Fprod uct%252FTAS2764.

However, a drawback of the known solution discussed above is that a conductive trace has to be provided on the board (PCB) to route the pull-up voltage $V_{pu}$ to the electronic device, and a pin of the electronic device has to be used for receiving the external pull-up voltage $V_{pu}$. In particular for low-cost devices, the available pin count is limited and dedicating one pin to receiving the external pull-up voltage $V_{pu}$ is undesirable.

Another document possibly of interest in this technological field is document US 10447269 B1, which discloses a level shifter circuit that can be used in the comparator of an I²C interface to shift the level of the received/transmitted I²C signal when the internal logic of the chip operates at a certain voltage (e.g., 1.8 V) that is different from the voltage of the external device coupled to the I²C interface (e.g., 1.2 V).

Other documents possibly of interest in this technological field include: CN 106844270 A; CN 112650377 A; WO 2020/218472 A1; CN 106788354 B; US 5166550 A; US 2007/0296478 A1; the document "TI Designs - Precision: Verified Design - Comparator with Hysteresis Reference Design" by Texas Instruments, TIDU020A, May 2013, Revised June 2014; the document "Analog Engineer's Circuit - Programmable comparator circuit with hysteresis or latching output" by Texas Instruments, SLAAE20, May 2021; and the document Y. Yao and M. Jiang, "Design of Hysteresis Comparator with Wide Common Mode Operating Range," 2022 IEEE 4th International Conference on Circuits and Systems (ICCS), Chengdu, China, 2022, pp. 91-94, doi: 10.1109/ICCS56666.2022.9936471.

None of these known solutions provides an I$^2$C interface circuit compatible with two (or more) different pull-up voltage levels and suitable for large hysteresis at the same time.

Therefore, there is a need in the art to provide improved I$^2$C interface circuits that facilitate solving the issue mentioned above.

<u>Object and summary</u>

One or more embodiments of the present disclosure contribute in providing improved I$^2$C interface circuits.

According to one or more embodiments, such an object can be achieved by an I$^2$C interface circuit having the features set forth in the claims that follow.

One or more embodiments may relate to a corresponding electronic device (e.g., a switching converter or switching power amplifier).

One or more embodiments may relate to a corresponding method of operation.

The claims are an integral part of the technical teaching provided herein in respect of the embodiments.

According to an aspect of the present description, an I$^2$C interface circuit is operatable at a low pull-up voltage and at a high pull-up voltage. The I$^2$C interface circuit includes a first pin configured to receive a clock signal and a second pin configured to receive a data signal. The I$^2$C interface circuit includes a first comparator stage coupled to the first pin and configured to compare the received clock signal to a low threshold and a high threshold to produce an internal clock signal. The I$^2$C interface circuit includes a second comparator stage coupled to the second pin and configured to compare the received data signal to the low threshold and the high threshold to produce an internal data signal. The first comparator stage and the second comparator stage are programmed by default to operate in a first operating mode. In the first operating mode the low threshold is set to a first fractional value of the high pull-up voltage and the high threshold is set to a second fractional value of the low pull-up voltage (e.g., with the first fractional value lower than the second fractional value). The first comparator stage and the second comparator stage are switchable, upon reception via the I$^2$C interface of a programming frame that conveys a current value of the pull-up voltage, to a second operating mode. In the second operating mode, the low threshold is set to the first fractional value of the current pull-up voltage and the high threshold is set to the second fractional value of the current pull-up voltage.

One or more embodiments may thus provide an I$^2$C interface circuit that is compatible with plural values of the pull-up voltage and is robust in terms of comparison hysteresis, without the need of routing the pull-up voltage to the interface itself.

According to another aspect of the present description, an electronic device includes an I$^2$C interface circuit according to one or more embodiments, and a processing circuit. The processing circuit is configured to receive, via the I$^2$C interface circuit, the programming frame that conveys the current value of the pull-up voltage, and switch the first comparator stage and the second comparator stage of the I$^2$C interface circuit to the second operating mode as a function thereof.

According to another aspect of the present description, a method of operating an I$^2$C interface circuit or an electronic device according to one or more embodiments includes:

- receiving a clock signal at the first pin and receiving a data signal at the second pin;
- comparing the received clock signal to a low threshold and a high threshold in the first comparator stage and producing an internal clock signal;
- comparing the received data signal to the low threshold and the high threshold in the second comparator stage and producing an internal data signal;
- programming by default the first comparator stage and the second comparator stage to operate in a first operating mode, wherein the low threshold is set to a first fractional value of the high pull-up voltage and the high threshold is set to a second fractional value of the low pull-up voltage; and
- switching, as a function of a programming frame received via the I$^2$C interface that conveys a current value of the pull-up voltage, the first comparator stage and the second comparator stage to a second operating mode, wherein the low threshold is set to the first fractional value of the current pull-up voltage and the high threshold is set to the second fractional value of the current pull-up voltage.

Brief description of the several views of the drawings

One or more embodiments will now be described, by way of example, with reference to the annexed figures, wherein:

- Figure 1 is a circuit block diagram exemplary of an I$^2$C interface circuit according to one or more embodiments of the present description;
- Figure 2 is a time diagram including waveforms exemplary of signals in an electronic device including an I$^2$C interface circuit according to one or more embodiments of the present description;
- Figure 3 is a circuit block diagram exemplary of an I$^2$C interface circuit according to further embodiments of the present description; and
- Figure 4 is a circuit block diagram exemplary of an I$^2$C interface circuit according to yet further embodiments of the present description.

Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

As known, an I$^2$C interface includes two (bidirectional) communication lines, in particular a serial data line (SDA) and a serial clock line (SCL). Therefore, an I$^2$C interface includes two I/O pins, each of which is connected to a respective comparator stage that is configured to discern between the high level and the low level of the respective input digital signal. In order to provide an I$^2$C interface circuit compatible with at least two different pull-up voltage levels $V_{pu\_low}$ (low value of $V_{pu}$) and $V_{pu\_high}$ (high value of $V_{pu}$) - and thus, different levels of the input digital signals - and also having large hysteresis, one or more embodiments relate to an I$^2$C interface circuit where the input comparator stage(s) are programmable, via the I$^2$C interface itself (i.e., without the need of resorting to additional I/O pins), so as to switch between:

- a first operating mode, where the comparator stage operates with small hysteresis but can operate indiscriminately with any of values $V_{pu\_low}$ and $V_{pu\_high}$ of the pull-up voltage (e.g., 1.8 V or 3.3 V); and
- a second operating mode, where the comparator stage is programmed to operate expecting a specific one of values $V_{pu\_low}$ and $V_{pu\_high}$ of the pull-up voltage (e.g., 1.8 V or 3.3 V), with a larger hysteresis.

In particular, at device start-up, the comparator stages operate by default with small hysteresis and can operate at any one of the possible values $V_{pu\_low}$ and $V_{pu\_high}$ of the pull-up voltage (e.g., 1.8 V and 3.3 V). During the start-up phase, the device is idle, so it does not generate noise (e.g., because there is no ongoing switching activity) and a small hysteresis (obtained by setting $V_{IH} = 0.7*V_{pu\_low}$ and $V_{IL} = 0.3*V_{pu\_high}$) is not an issue. In this phase, the I$^2$C interface receives a frame indicating whether the actual pull-up voltage is equal to $V_{pu\_low}$ (e.g., 1.8 V) or $V_{pu\_high}$ (e.g., 3.3 V). Depending on this message, the comparator stages are programmed with the corresponding thresholds $V_{IH}$ and $V_{IL}$ (e.g., $V_{IH} = 0.7*V_{pu\_low}$ and $V_{IL} = 0.3*V_{pu\_low}$ if $V_{pu} = V_{pu\_low}$, and $V_{IH} = 0.7*V_{pu\_high}$ and $V_{IL} = 0.3*V_{pu\_high}$ if $V_{pu} = V_{pu\_high}$, which result respectively in $V_{IH} = 1.26$ V and $V_{IL} = 0.54$ V if $V_{pu} = V_{pu\_low} = 1.8$ V, and $V_{IH} = 2.31$ V and $V_{IL} = 0.99$ V if $V_{pu} = V_{pu\_high} = 3.3$ V). Therefore, after being programmed, the comparator stage operates with larger hysteresis, and provides good rejection against the noise generated by the switching components of the device.

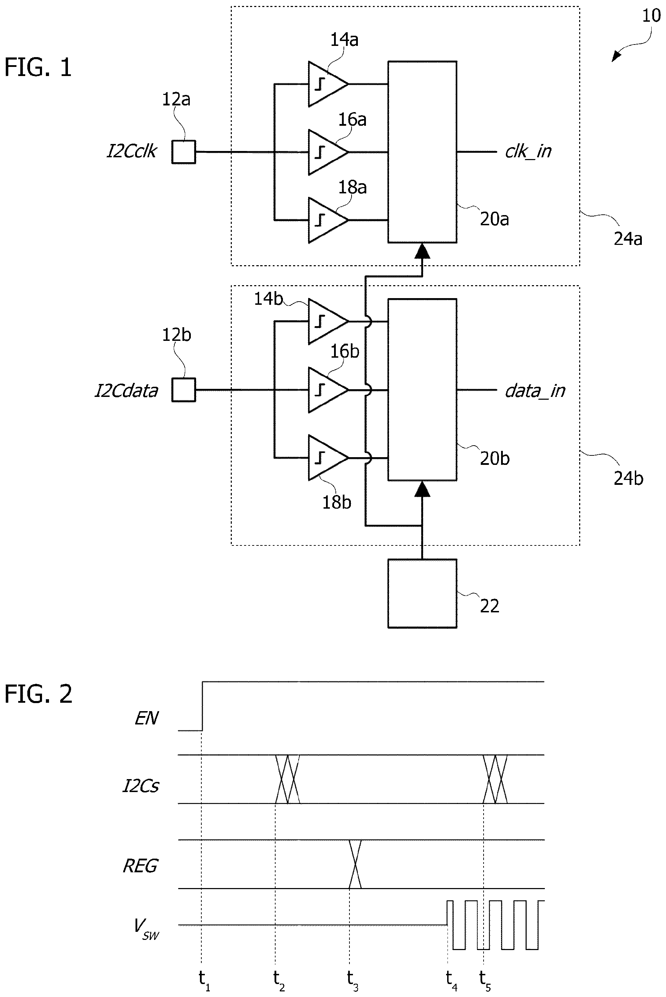

Operation as described above can be achieved by different architectures of the comparator stage of the I$^2$C interface, as illustrated for instance in the example embodiments of Figures 1, 3 and 4.

Figure 1 is a circuit block diagram exemplary of an I$^2$C interface circuit 10 according to one or more embodiments of the present description. The I$^2$C interface includes a first I/O pin 12a configured to receive a clock signal *I2Cclk,* and a second I/O pin 12b configured to receive a data signal *I2Cdata.* At least three comparators 14a, 16a and 18a are coupled to pin 12a to receive signal *I2Cclk,* and similarly at least three comparators 14b, 16b and 18b are coupled to pin 12b to receive signal *I2Cdata.* Comparators 14a and 14b (also referred to as "combi" comparators) are compatible with all the possible levels of the pull-up voltage (i.e., at least $V_{pu\_low}$ and $V_{pu\_high}$) that the I$^2$C interface is expected to operate with (e.g., possible values of CMOS supply voltage). In other words, the comparison thresholds of comparators 14a and 14b are set as follows: $V_{IH} = 0.7*V_{pu\_low}$ and $V_{IL} = 0.3*V_{pu\_high}$. As discussed previously, $V_{pu\_low}$ may be equal to 1.8 V and $V_{pu\_high}$ may be equal to 3.3 V, but other values are possible; for instance, the pull-up voltage may be equal to 5 V. By setting these values of the thresholds $V_{IH}$ and $V_{IL}$, comparators 14a and 14b have a small hysteresis but this is not an issue as long as there is no switching activity in the device (e.g., at start-up) and thus electronic noise is low. Comparators 16a and 16b are compatible with a specific one of the voltage levels of the pull-up voltage (e.g., specifically compatible with $V_{pu\_low}$). In other words, the comparison thresholds of comparators 16a and 16b are set as follows: $V_{IH} = 0.7*V_{pu\_low}$ and $V_{IL} = 0.3*V_{pu\_low}$. By setting these values of the thresholds $V_{IH}$ and $V_{IL}$, comparators 16a and 16b have a large hysteresis and are adapted to operate with $V_{pu} = V_{pu\_low}$ even if the I$^2$C interface is affected by switching noise. Similarly, comparators 18a and 18b are compatible with another specific one of the voltage levels of the pull-up voltage (e.g., specifically compatible with $V_{pu\_high}$). In other words, the comparison thresholds of comparators 18a and 18b are set as follows: $V_{IH} = 0.7*V_{pu\_high}$ and $V_{IL} = 0.3*V_{pu\_high}$. By setting these values of the thresholds $V_{IH}$ and $V_{IL}$, comparators 18a and 18b have a large hysteresis and are adapted to operate with $V_{pu} = V_{pu\_high}$ even if the I$^2$C interface is affected by switching noise. A first multiplexer 20a is coupled to the output terminals of comparators 14a, 16a and 18a in the first communication line of the I$^2$C interface, and a second multiplexer 20b is coupled to the output terminals of comparators 14b, 16b and 18b in the second communication line of the I$^2$C interface. Therefore, multiplexer 20a propagates to the internal circuits of the device, as internal clock signal *clk_in,* one of the output signals from comparators 14a, 16a and 18a, and multiplexer 20b propagates to the internal circuits of the device, as internal data signal *data_in,* one of the output signals from comparators 14b, 16b and 18b. Multiplexers 20a and 20b are controlled by a selection signal REG provided by a programmable register 22. Comparators 14a, 16a and 18a together with multiplexer 20a make up a first comparator stage 24a, while comparators 14b, 16b and 18b together with multiplexer 20b make up a second comparator stage 24b.

Operation of the I$^2$C interface circuit 10 as exemplified in Figure 1 may be additionally understood by referring to Figure 2, which is a time diagram that exemplifies possible waveforms of an enable signal EN, of the I$^2$C signals *I2Cclk* and *I2Cdata* (collectively referred to as signals *I2Cs*), of a selection signal *REG,* and of the output voltage $V_{SW}$ of a switching power stage provided in the electronic device. By default, at start-up (indicated by assertion of the enable signal EN at instant $t_1$), register 22 sets the value of the selection signal *REG* so that multiplexers 20a and 20b propagate the signal output by comparators 14a and 14b (combi comparators), respectively. Therefore, at start-up, the I$^2$C interface 10 operates with small hysteresis and full compatibility with different values of the pull-up voltage, and soon receives an I$^2$C programming frame (write frame) that communicates the current value of the pull-up voltage (see instant $t_2$ in Figure 2). Once the programming frame is received, this is processed by the device and the register 22 is programmed (see instant $t_3$ in Figure 2) in such a way that it outputs the selection signal REG with a value that controls multiplexers 20a and 20b to propagate the signal output by comparators 16a, 16b or alternatively 18a, 18b depending on the current value of the pull-up voltage. Once the output from comparators 16a, 16b or 18a, 18b is selected, the I$^2$C interface circuit 10 operates with sufficient hysteresis so that, even after the switching activity of signal $V_{SW}$ begins (see instant $t_4$ in Figure 2), further I$^2$C frames can be received (see instant $t_5$ in Figure 2) and correctly decoded by using the correct comparators.

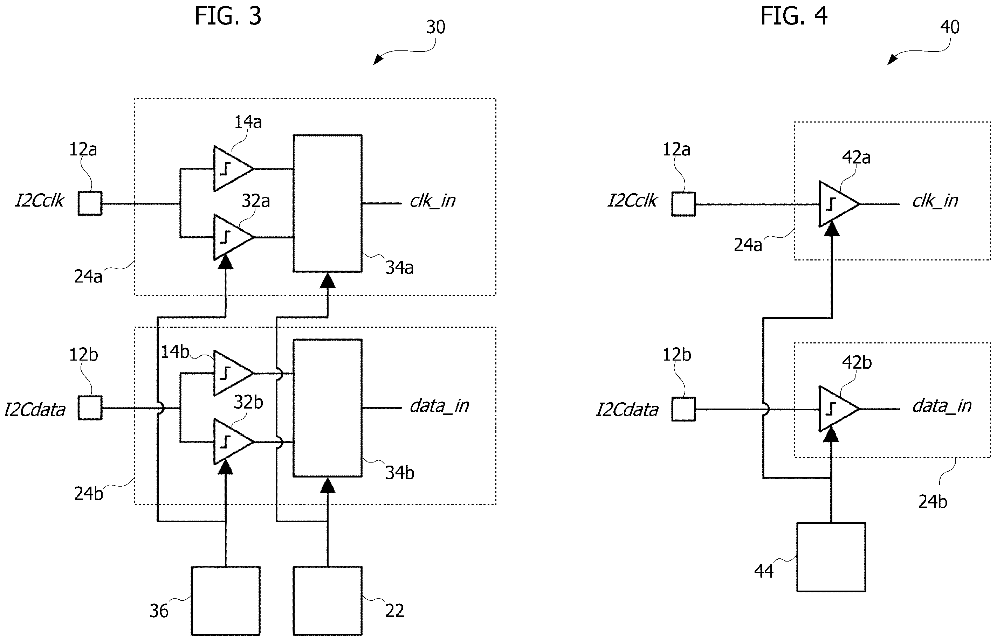

Figure 3 is a circuit block diagram exemplary of an I$^2$C interface circuit 30 according to further embodiments of the present description. Elements identical or similar to those discussed with reference to Figure 1 are indicated by identical or similar references, and a corresponding description is not repeated for brevity. Differently from the embodiments of Figure 1, the embodiments of Figure 3 include a reconfigurable comparator 32a in the place of comparators 16a and 18a, and a reconfigurable comparator 32b in the place of comparators 16b and 18b (while comparators 14a and 14b are the same as before). Comparators 32a and 32b can be selectively configured (e.g., programmed) to be compatible with a selected one of the voltage levels of the pull-up voltage (e.g., specifically compatible with $V_{pu\_low}$ or with $V_{pu\_high}$), depending on the value of a further selection signal provided by a further programmable register 36. In other words, the comparison thresholds of comparators 32a and 32b can be set as follows: $V_{IH} = 0.7*V_{pu\_low}$ and $V_{IL} = 0.3*V_{pu\_low}$ for a first value of the further selection signal, and $V_{IH} = 0.7*V_{pu\_high}$ and $V_{IL} = 0.3*V_{pu\_high}$ for a second value of the further selection signal. Configurability of comparators 32a and 32b may be obtained, for instance, implementing the comparators with pass gates, which allow to configure the thresholds. Multiplexers 34a and 34b operate substantially as multiplexers 20a and 20b, directed by the selection signal REG output by register 22, but can select from the output of comparators 14a, 32a and 14b, 32b, respectively. Comparators 14a and 32a together with multiplexer 34a make up the first comparator stage 24a, while comparators 14b and 32b together with multiplexer 34b make up the second comparator stage 24b.

Operation of the I$^2$C interface circuit 30 as exemplified in Figure 3 is substantially very similar to operation of the circuit of Figure 1, as discussed with reference to Figure 2. At start-up, register 22 outputs a selection signal REG that controls multiplexers 34a and 34b so as to propagate the signal output by comparators 14a and 14b (combi comparators), respectively. Once the I$^2$C programming frame that communicates the current value of the pull-up voltage is received, this is processed by the device and the registers 22 and 36 are programmed. In particular, register 22 is programmed in such a way that it outputs a selection signal REG that controls multiplexers 34a and 34b to propagate the signals output by comparators 32a and 32b (independently from the current value of the pull-up voltage), and register 36 is programmed in such a way that it outputs a further selection signal that controls comparators 32a and 32b to set their thresholds depending on the current value of the pull-up voltage. Once the comparators 32a and 32b are programmed, the I²C interface circuit 30 operates with sufficient hysteresis so that, even after the switching activity of signal $V_{SW}$ begins, further I²C frames can be received and correctly decoded.

Figure 4 is a circuit block diagram exemplary of an I²C interface circuit 40 according to further embodiments of the present description. Elements identical or similar to those discussed with reference to Figures 1 and 3 are indicated by identical or similar references, and a corresponding description is not repeated for brevity. Differently from the embodiments of Figures 1 and 3, the embodiments of Figure 4 include a single reconfigurable comparator 42a coupled to pin 12a to receive signal *I2Cclk* and produce signal *clk_in,* and a single reconfigurable comparator 42b coupled to pin 12b to receive signal *I2Cdata* and produce signal *data_in.* Substantially, comparators 42a and 42b can be selectively configured (e.g., programmed) to operate as the "combi" comparators 14a and 14b or as the dedicated comparators 32a, 32b depending on the value of a selection signal provided by a programmable register 44. In other words, depending on the value of the selection signal output by register 44, the comparison thresholds of comparators 42a and 42b can be set as follows: $V_{IH} = 0.7*V_{pu\_low}$ and $V_{IL} = 0.3*V_{pu\_high}$ for a first value of the selection signal, $V_{IH} = 0.7*V_{pu\_low}$ and $V_{IL} = 0.3*V_{pu\_low}$ for a second value of the selection signal, and $V_{IH} = 0.7*V_{pu\_high}$ and $V_{IL} = 0.3*V_{pu\_high}$ for a third value of the selection signal. Configurability of comparators 42a and 42b may be obtained, for instance, implementing the comparators with pass gates, which allow to configure the thresholds. The embodiments of Figure 4 do not include multiplexers. Thus, comparators 42a makes up the first comparator stage 24a, while comparator 42b makes up the second comparator stage 24b.

Operation of the I²C interface circuit 40 as exemplified in Figure 4 is substantially very similar to operation of the circuits of Figures 1 and 3, as discussed with reference to Figure 2. By default, at start-up, register 44 outputs a selection signal that controls comparators 42a and 42b to set their thresholds according to the "combi" configuration. Once the I²C programming frame that communicates the current value of the pull-up voltage is received, this is processed by the device and the register 44 is programmed. In particular, register 44 is programmed in such a way that it outputs a selection signal that controls comparators 42a and 42b to set their thresholds depending on the current value of the pull-up voltage. Once the comparators 42a and 42b are programmed, the I²C interface circuit 40 operates with sufficient hysteresis so that, even after the switching activity of signal $V_{SW}$ begins, further I²C frames can be received and correctly decoded.

With the novel architecture of the I²C interface disclosed herein, there is no need to bring the pull-up voltage $V_{pu}$ to the device (insofar as the value of the pull-up voltage $V_{pu}$ is communicated to the device via an I²C message during the start-up phase, when rejection to noise is not an issue), thus saving one conductive trace on the PCB and reducing the pin count of the integrated circuit.

Without prejudice to the underlying principles, the details and embodiments may vary, even significantly, with respect to what has been described by way of example, without departing from the extent of protection.

The extent of protection is determined by the annexed claims.

**Claims**

1. An I²C interface circuit (10; 30; 40) operatable at a low pull-up voltage and at a high pull-up voltage, the I²C interface circuit comprising:

   a first pin (12a) configured to receive a clock signal *(I2Cclk)* and a second pin (12b) configured to receive a data signal *(I2Cdata)*;
   a first comparator stage (24a) coupled to said first pin (12a) and configured to compare the received clock signal *(I2Cclk)* to a low threshold ($V_{IL}$) and a high threshold ($V_{IH}$) to produce an internal clock signal (*clk_in*);
   a second comparator stage (24b) coupled to said second pin (12b) and configured to compare the received data signal (*I2Cdata*) to said low threshold ($V_{IL}$) and said high threshold ($V_{IH}$) to produce an internal data signal (*data_in*);
   wherein the first comparator stage (24a) and the second comparator stage (24b) are programmed by default to operate in a first operating mode, wherein said low threshold ($V_{IL}$) is set to a first fractional value of said high pull-up voltage and said high threshold ($V_{IH}$) is set to a second fractional value of said low pull-up voltage;
   and wherein the first comparator stage (24a) and the second comparator stage (24b) are switchable, upon reception via the I²C interface of a programming frame that conveys a current value of the pull-up voltage, to a second operating mode, wherein said low threshold ($V_{IL}$) is set to said first fractional value of the current pull-up voltage and said high threshold ($V_{IH}$) is set to said second fractional value of the current pull-up voltage.

2. The I²C interface circuit (10) of claim 1, wherein each of said first (24a) and second (24b) comparator stages comprises:

a first comparator (14a, 14b) having its low threshold ($V_{IL}$) set to said first fractional value of said high pull-up voltage and its high threshold ($V_{IH}$) set to said second fractional value of said low pull-up voltage;

a second comparator (16a, 16b) having its low threshold ($V_{IL}$) set to said first fractional value of said low pull-up voltage and its high threshold ($V_{IH}$) set to said second fractional value of said low pull-up voltage; and

a third comparator (18a, 18b) having its low threshold ($V_{IL}$) set to said first fractional value of said high pull-up voltage and its high threshold ($V_{IH}$) set to said second fractional value of said high pull-up voltage; and

a multiplexer (20a, 20b) configured to propagate one of the outputs from said first (14a, 14b), second (16a, 16b) and third (18a, 18b) comparators as a function of the value of a programmable register (22);

wherein said programmable register (22) is set by default to a first value that causes said multiplexers (20a, 20b) to propagate the outputs from said first comparators (14a, 14b), and is programmable by said programming frame to:

a second value that causes said multiplexers (20a, 20b) to propagate the outputs from said second comparators (16a, 16b) if the current value of the pull-up voltage is equal to said low pull-up voltage, and

a third value that causes said multiplexers (20a, 20b) to propagate the outputs from said third comparators (18a, 18b) if the current value of the pull-up voltage is equal to said high pull-up voltage.

3. The I$^2$C interface circuit (30) of claim 1, wherein each of said first (24a) and second (24b) comparator stages comprises:

a first comparator (14a, 14b) having its low threshold ($V_{IL}$) set to said first fractional value of said high pull-up voltage and its high threshold ($V_{IH}$) set to said second fractional value of said low pull-up voltage; and

a second comparator (32a, 32b) selectively switchable between a first comparison mode and a second comparison mode as a function of the value of a first programmable register (36), wherein in the first comparison mode the low threshold ($V_{IL}$) is set to said first fractional value of said low pull-up voltage and the high threshold ($V_{IH}$) is set to said second fractional value of said low pull-up voltage, and in the second comparison mode the low threshold ($V_{IL}$) is set to said first fractional value of said high pull-up voltage and the high threshold ($V_{IH}$) is set to said second fractional value of said high pull-up voltage; and

a multiplexer (34a, 34b) configured to propagate one of the outputs from said first (14a, 14b) and second (32a, 32b) comparators as a function of the value of a second programmable register (22);

wherein said second programmable register (22) is set by default to a first value that causes said multiplexers (34a, 34b) to propagate the outputs from said first comparators (14a, 14b), and is programmable, in response to said programming frame being received, to a second value that causes said multiplexers (34a, 34b) to propagate the outputs from said second comparators (32a, 32b);

and wherein said first programmable register (36) is programmable by said programming frame to:

a first value that causes the second comparators (32a, 32b) to operate in the first comparison mode, if the current value of the pull-up voltage is equal to said low pull-up voltage, and

a second value that causes the second comparators (32a, 32b) to operate in the second comparison mode, if the current value of the pull-up voltage is equal to said high pull-up voltage.

4. The I$^2$C interface circuit (40) of claim 1, wherein each of said first (24a) and second (24b) comparator stages comprises a comparator (42a, 42b) selectively switchable between a first, a second and a third comparison mode as a function of the value of a programmable register (44), wherein:

in the first comparison mode the low threshold ($V_{IL}$) is set to said first fractional value of said high pull-up voltage and the high threshold ($V_{IH}$) is set to said second fractional value of said low pull-up voltage;

in the second comparison mode the low threshold ($V_{IL}$) is set to said first fractional value of said low pull-up voltage and the high threshold ($V_{IH}$) is set to said second fractional value of said low pull-up voltage; and

in the third comparison mode the low threshold ($V_{IL}$) is set to said first fractional value of said high pull-up voltage and the high threshold ($V_{IH}$) is set to said second fractional value of said high pull-up voltage;

wherein said programmable register (44) is set by default to a first value that causes said comparators (42a, 42b) to operate in the first comparison mode, and is programmable by said programming frame to:

a second value that causes the comparators (42a, 42b) to operate in the second comparison mode, if the current value of the pull-up voltage is equal to said low pull-up voltage, and

a third value that causes the comparators (42a, 42b) to operate in the third comparison mode, if the current value of the pull-up voltage is equal to said high pull-up voltage.

5. The I$^2$C interface circuit (10; 30; 40) of any of the previous claims, wherein said low pull-up voltage is equal to about 1.8 V and said high pull-up voltage is equal to about 3.3 V.

6. The I$^2$C interface circuit (10; 30; 40) of any of the previous claims, wherein said first fractional value is equal to about 0.3 and said second fractional value is equal to about 0.7.

7. An electronic device, comprising:

an I$^2$C interface circuit (10; 30; 40) according to any of the previous claims; and
a processing circuit configured to:

receive, via the I$^2$C interface circuit, said programming frame that conveys the current value of the pull-up voltage; and
switch said first comparator stage (24a) and said second comparator stage (24b) of the I$^2$C interface circuit (10; 30; 40) to said second operating mode as a function of said programming frame.

8. A method of operating an I$^2$C interface circuit (10; 30; 40) according to any of claims 1 to 6 or an electronic device according to claim 7, the method comprising:

receiving a clock signal (*I2Cclk*) at said first pin (12a) and receiving a data signal (*I2Cdata*) at said second pin (12b);
comparing the received clock signal (*I2Cclk*) to a low threshold ($V_{IL}$) and a high threshold ($V_{IH}$) in said first comparator stage (24a) and producing an internal clock signal (*clk_in*);
comparing the received data signal (*I2Cdata*) to said low threshold ($V_{IL}$) and said high threshold ($V_{IH}$) in said second comparator stage (24b) and producing an internal data signal (*data_in*);
programming by default the first comparator stage (24a) and the second comparator stage (24b) to operate in a first operating mode, wherein said low threshold ($V_{IL}$) is set to a first fractional value of said high pull-up voltage and said high threshold ($V_{IH}$) is set to a second fractional value of said low pull-up voltage; and
switching, as a function of a programming frame received via the I$^2$C interface that conveys a current value of the pull-up voltage, the first comparator stage (24a) and the second comparator stage (24b) to a second operating mode, wherein said low threshold ($V_{IL}$) is set to said first fractional value of the current pull-up voltage and said high threshold ($V_{IH}$) is set to said second fractional value of the current pull-up voltage.

## Patentansprüche

1. I$^2$C-Schnittstellenschaltung (10; 30; 40), die bei einer niedrigen Pull-up-Spannung und bei einer hohen Pull-up-Spannung betrieben werden kann, wobei die I$^2$C-Schnittstellenschaltung umfasst:

einen ersten Pin (12a), der so konfiguriert ist, dass er ein Taktsignal (*I2Cclk*) empfängt, und einen zweiten Pin (12b), der so konfiguriert ist, dass er ein Datensignal (*I2Cdata*) empfängt;
eine erste Komparatorstufe (24a), die mit dem ersten Pin (12a) gekoppelt und so konfiguriert ist, dass sie das empfangene Taktsignal (*I2Cclk*) mit einem unteren Schwellenwert ($V_{IL}$) und einem oberen Schwellenwert ($V_{IH}$) vergleicht, um ein internes Taktsignal (*clk_in*) zu erzeugen;
eine zweite Komparatorstufe (24b), die mit dem zweiten Pin (12b) gekoppelt und so konfiguriert ist, dass sie das empfangene Datensignal (*I2Cdata*) mit dem unteren Schwellenwert ($V_{IL}$) und dem oberen Schwellenwert ($V_{IH}$) vergleicht, um ein internes Datensignal (*data_in*) zu erzeugen;
wobei die erste Komparatorstufe (24a) und die zweite Komparatorstufe (24b) standardmäßig so programmiert sind, dass sie in einem ersten Betriebsmodus arbeiten, wobei der untere Schwellenwert ($V_{IL}$) auf einen ersten Bruchteilwert der hohen Pull-up-Spannung eingestellt ist und der obere Schwellenwert ($V_{IH}$) auf einen zweiten Bruchteilwert der niedrigen Pull-up-Spannung eingestellt ist;
und wobei die erste Komparatorstufe (24a) und die zweite Komparatorstufe (24b) bei dem Empfang eines Programmierrahmens über die I$^2$C-Schnittstelle, der einen aktuellen Wert der Pull-up-Spannung übermittelt, in einen zweiten Betriebsmodus umschaltbar sind, wobei der untere Schwellenwert ($V_{IL}$) auf den ersten Bruchteilwert der aktuellen Pull-up-Spannung eingestellt ist und der obere Schwellenwert ($V_{IH}$) auf den zweiten Bruchteilwert der aktuellen Pull-up-Spannung eingestellt ist.

2. I$^2$C-Schnittstellenschaltung (10) nach Anspruch 1, wobei jede der ersten (24a) und der zweiten (24b) Vergleicherstufe Folgendes umfasst:

einen ersten Komparator (14a, 14b), dessen unterer Schwellenwert ($V_{IL}$) auf den ersten Bruchteilwert der hohen Pull-up-Spannung eingestellt ist und dessen oberer Schwellenwert ($V_{IH}$) auf den zweiten Bruchteilwert der niedrigen Pull-up-Spannung eingestellt ist;
einen zweiten Komparator (16a, 16b), dessen unterer Schwellenwert ($V_{IL}$) auf den ersten Bruchteilwert der niedrigen Pull-up-Spannung eingestellt ist und dessen oberer Schwellenwert ($V_{IH}$) auf den zweiten Bruchteilwert der niedrigen Pull-up-Spannung eingestellt ist; und
einen dritten Komparator (18a, 18b), dessen unterer Schwellenwert ($V_{IL}$) auf den ersten Bruchteilwert der hohen Pull-up-Spannung eingestellt ist und dessen oberer Schwellenwert ($V_{IH}$) auf den zweiten Bruchteilwert der hohen Pull-up-Spannung eingestellt ist; und
einen Multiplexer (20a, 20b), der so konfiguriert ist, dass er einen der Ausgänge von den ersten (14a, 14b), zweiten (16a, 16b) und dritten (18a, 18b) Komparatoren als Funktion des Wertes eines programmierbaren Registers (22) weiterleitet;
wobei das programmierbare Register (22) standardmäßig auf einen ersten Wert eingestellt ist, der die Multiplexer (20a, 20b) dazu veranlasst, die Ausgänge von den ersten Komparatoren (14a, 14b) weiterzuleiten, und durch den Programmierrahmen auf Folgendes programmierbar ist:

einen zweiten Wert, der veranlasst, dass die Multiplexer (20a, 20b) die Ausgänge von den zweiten Komparatoren (16a, 16b) weiterleiten, wenn der aktuelle Wert der Pull-up-Spannung gleich der niedrigen Pull-up-Spannung ist, und
einen dritten Wert, der veranlasst, dass die Multiplexer (20a, 20b) die Ausgänge der dritten Komparatoren (18a, 18b) weiterleiten, wenn der aktuelle Wert der Pull-up-Spannung gleich der hohen Pull-up-Spannung ist.

3. I$^2$C-Schnittstellenschaltung (30) nach Anspruch 1, wobei jede der ersten (24a) und der zweiten (24b) Komparatorstufe umfasst:

einen ersten Komparator (14a, 14b), dessen unterer Schwellenwert ($V_{IL}$) auf den ersten Bruchteilwert der hohen Pull-up-Spannung eingestellt ist und dessen oberer Schwellenwert ($V_{IH}$) auf den zweiten Bruchteilwert der niedrigen Pull-up-Spannung eingestellt ist; und
einen zweiten Komparator (32a, 32b), der selektiv zwischen einem ersten Vergleichsmodus und einem zweiten Vergleichsmodus als Funktion des Wertes eines ersten programmierbaren Registers (36) umschaltbar ist, wobei in dem ersten Vergleichsmodus der untere Schwellenwer ($V_{IL}$) auf den ersten Bruchteilwert der niedrigen Pull-up-Spannung eingestellt ist und der obere Schwellenwert ($V_{IH}$) auf den zweiten Bruchteilwert der niedrigen Pull-up-Spannung eingestellt ist und in dem zweiten Vergleichsmodus der untere Schwellenwert ($V_{IL}$) auf den ersten Bruchteilwert der hohen Pull-up-Spannung eingestellt ist und der obere Schwellenwert ($V_{IH}$) auf den zweiten Bruchteilwert der hohen Pull-up-Spannung eingestellt ist; und
einen Multiplexer (34a, 34b), der so konfiguriert ist, dass er einen der Ausgänge von den ersten (14a, 14b) und zweiten (32a, 32b) Komparatoren als Funktion des Wertes eines zweiten programmierbaren Registers (22) weiterleitet;
wobei das zweite programmierbare Register (22) standardmäßig auf einen ersten Wert eingestellt ist, der veranlasst, dass die Multiplexer (34a, 34b) die Ausgänge von den ersten Komparatoren (14a, 14b) weiterleiten, und als Reaktion auf den empfangenen Programmierrahmen auf einen zweiten Wert programmierbar ist, der die Multiplexer (34a, 34b) dazu veranlasst, die Ausgänge der zweiten Komparatoren (32a, 32b) weiterzuleiten;
und wobei das erste programmierbare Register (36) durch den Programmierrahmen auf Folgendes programmierbar ist:

einen ersten Wert, der veranlasst, dass die zweiten Komparatoren (32a, 32b) in dem ersten Vergleichsmodus arbeiten, wenn der aktuelle Wert der Pull-up-Spannung gleich der niedrigen Pull-up-Spannung ist, und
einen zweiten Wert, der veranlasst, dass die zweiten Komparatoren (32a, 32b) in dem zweiten Vergleichsmodus arbeiten, wenn der aktuelle Wert der Pull-up-Spannung gleich der hohen Pull-up-Spannung ist.

4. I$^2$C-Schnittstellenschaltung (40) nach Anspruch 1, wobei jeweils die erste (24a) und die zweiten (24b) Komparatorstufe einen Komparator (42a, 42b) umfasst, der selektiv zwischen einem ersten, einem zweiten und einem dritten Vergleichsmodus als Funktion des Wertes eines programmierbaren Registers (44) umschaltbar ist, wobei:

in dem ersten Vergleichsmodus der untere Schwellenwert ($V_{IL}$) auf den ersten Bruchteilwert der hohen Pull-up-Spannung eingestellt wird und der obere Schwellenwert ($V_{IH}$) auf den zweiten Bruchteilwert der niedrigen Pull-up-Spannung eingestellt wird;

in dem zweiten Vergleichsmodus der untere Schwellenwert ($V_{IL}$) auf den ersten Bruchteilwert der niedrigen Pull-up-Spannung eingestellt wird und der obere Schwellenwert ($V_{IH}$) auf den zweiten Bruchteilwert der niedrigen Pull-up-Spannung eingestellt wird; und

in dem dritten Vergleichsmodus der untere Schwellenwert ($V_{IL}$) auf den ersten Bruchteilwert der hohen Pull-up-Spannung eingestellt wird und der obere Schwellenwert ($V_{IH}$) auf den zweiten Bruchteilwert der hohen Pull-up-Spannung eingestellt wird;

wobei das programmierbare Register (44) standardmäßig auf einen ersten Wert eingestellt ist, der veranlasst, dass die Komparatoren (42a, 42b) in dem ersten Vergleichsmodus arbeiten, und durch den Programmierrahmen auf Folgendes programmierbar ist:

einen zweiten Wert, der veranlasst, dass die Komparatoren (42a, 42b) in dem zweiten Vergleichsmodus arbeiten, wenn der aktuelle Wert der Pull-up-Spannung gleich der niedrigen Pull-up-Spannung ist, und einen dritten Wert, der veranlasst, dass die Komparatoren (42a, 42b) in dem dritten Vergleichsmodus arbeiten, wenn der aktuelle Wert der Pull-up-Spannung gleich der hohen Pull-up-Spannung ist.

5. I$^2$C-Schnittstellenschaltung (10; 30; 40) nach einem der vorhergehenden Ansprüche, wobei die niedrige Pull-up-Spannung etwa 1,8 V und die hohe Pull-up-Spannung etwa 3,3 V beträgt.

6. I$^2$C-Schnittstellenschaltung (10; 30; 40) nach einem der vorhergehenden Ansprüche, wobei der erste Bruchteilwert etwa 0,3 und der zweite Bruchteilwert etwa 0,7 beträgt.

7. Elektronische Vorrichtung, umfassend:

eine I$^2$C-Schnittstellenschaltung (10; 30; 40) nach einem der vorhergehenden Ansprüche, und eine Verarbeitungsschaltung, die für Folgendes konfiguriert ist:

Empfangen des Programmierrahmens über die I$^2$C-Schnittstellenschaltung, der den aktuellen Wert der Pull-up-Spannung übermittelt; und

Schalten der ersten Komparatorstufe (24a) und der zweiten Komparatorstufe (24b) der I$^2$C-Schnittstellen-schaltung (10; 30; 40) als Funktion des Programmierrahmens in den zweiten Betriebsmodus.

8. Verfahren zum Betreiben einer I$^2$C-Schnittstellenschaltung (10; 30; 40) nach einem der Ansprüche 1 bis 6 oder einer elektronischen Vorrichtung nach Anspruch 7, wobei das Verfahren Folgendes umfasst:

Empfangen eines Taktsignals (*I2Cclk*) an dem ersten Pin (12a) und Empfangen eines Datensignals (*I2Cdata*) an dem zweiten Pin (12b);

Vergleichen des empfangenen Taktsignals (*I2Cclk*) mit einem unteren Schwellenwert ($V_{IL}$) und einem oberen Schwellenwert ($V_{IH}$) in der ersten Komparatorstufe (24a) und Erzeugen eines internen Taktsignals (*clk_in*);

Vergleichen des empfangenen Datensignals (*I2Cdata*) mit dem unteren Schwellenwert ($V_{IL}$) und dem oberen Schwellenwert ($V_{IH}$) in der zweiten Komparatorstufe (24b) und Erzeugen eines internen Datensignals (*data_in*);

standardmäßiges Programmieren der ersten Komparatorstufe (24a) und der zweiten Komparatorstufe (24b), um in einem ersten Betriebsmodus zu arbeiten, wobei der untere Schwellenwert ($V_{IL}$) auf einen ersten Bruchteilwert der hohen Pull-up-Spannung eingestellt ist und der obere Schwellenwert ($V_{IH}$) auf einen zweiten Bruchteilwert der niedrigen Pull-up-Spannung eingestellt ist; und

Schalten, als Funktion eines über die I$^2$C-Schnittstelle empfangenen Programmierrahmens, der einen aktuellen Wert der Pull-up-Spannung übermittelt, der ersten Komparatorstufe (24a) und der zweiten Komparatorstufe (24b) in einen zweiten Betriebsmodus, wobei der untere Schwellenwert ($V_{IL}$) auf den ersten Bruchteilwert der aktuellen Pull-up-Spannung eingestellt ist und der obere Schwellenwert ($V_{IH}$) auf den zweiten Bruchteilwert der aktuellen Pull-up-Spannung eingestellt ist.

**Revendications**

1. Circuit d'interface I$^2$C (10 ; 30 ; 40) utilisable avec une basse tension de rappel vers le niveau haut et avec une haute tension de rappel vers le niveau haut, le circuit d'interface I$^2$C comprenant :

   une première broche (12a) configurée pour recevoir un signal d'horloge (*I2Cclk*) et une deuxième broche (12b) configurée pour recevoir un signal de données (*I2Cdata*) ;
   un premier étage comparateur (24a) couplé à ladite première broche (12a) et configuré pour comparer le signal d'horloge reçu (*I2Cclk*) avec un seuil bas ($V_{IL}$) et un seuil haut ($V_{IH}$) afin de produire un signal d'horloge interne (*clk_in*) ;
   un deuxième étage comparateur (24b) couplé à ladite deuxième broche (12b) et configuré pour comparer le signal de données reçu (*I2Cdata*) avec ledit seuil bas ($V_{IL}$) et ledit seuil haut ($V_{IH}$) afin de produire un signal de données interne (*data_in*) ;
   dans lequel le premier étage comparateur (24a) et le deuxième étage comparateur (24b) sont programmés par défaut pour fonctionner dans un premier mode de fonctionnement, dans lequel ledit seuil bas ($V_{IL}$) est réglé sur une première valeur fractionnelle de ladite haute tension de rappel vers le niveau haut et ledit seuil haut ($V_{IH}$) est réglé sur une deuxième valeur fractionnelle de ladite basse tension de rappel vers le niveau haut ;
   et dans lequel le premier étage comparateur (24a) et le deuxième étage comparateur (24b) sont commutables, après réception via l'interface I$^2$C d'une trame de programmation qui porte une valeur courante de la tension de rappel vers le niveau haut, vers un deuxième mode de fonctionnement, dans lequel ledit seuil bas ($V_{IL}$) est réglé sur ladite première valeur fractionnelle de la tension de rappel vers le niveau haut courante et ledit seuil haut ($V_{IH}$) est réglé sur ladite deuxième valeur fractionnelle de la tension de rappel vers le niveau haut courante.

2. Circuit d'interface I$^2$C (10) selon la revendication 1, dans lequel chacun desdits premier (24a) et deuxième (24b) étages comparateurs comprend :

   un premier comparateur (14a, 14b) dont le seuil bas ($V_{IL}$) est réglé sur ladite première valeur fractionnelle de ladite haute tension de rappel vers le niveau haut et dont le seuil haut ($V_{IH}$) est réglé sur ladite deuxième valeur fractionnelle de ladite basse tension de rappel vers le niveau haut ;
   un deuxième comparateur (16a, 16b) dont le seuil bas ($V_{IL}$) est réglé sur ladite première valeur fractionnelle de ladite basse tension de rappel vers le niveau haut et dont le seuil haut ($V_{IH}$) est réglé sur ladite deuxième valeur fractionnelle de ladite basse tension de rappel vers le niveau haut ; et
   un troisième comparateur (18a, 18b) dont le seuil bas ($V_{IL}$) est réglé sur ladite première valeur fractionnelle de ladite haute tension de rappel vers le niveau haut et dont le seuil haut ($V_{IH}$) est réglé sur ladite deuxième valeur fractionnelle de ladite haute tension de rappel vers le niveau haut ; et
   un multiplexeur (20a, 20b) configuré pour propager l'une des sorties desdits premier (14a, 14b), deuxième (16a, 16b) et troisième (18a, 18b) comparateurs en fonction de la valeur d'un registre programmable (22) ;
   dans lequel ledit registre programmable (22) est réglé par défaut sur une première valeur qui fait propager par lesdits multiplexeurs (20a, 20b) les sorties desdits premiers comparateurs (14a, 14b), et est programmable par ladite trame de programmation pour :

      prendre une deuxième valeur qui fait propager par lesdits multiplexeurs (20a, 20b) les sorties desdits deuxièmes comparateurs (16a, 16b) si la valeur courante de la tension de rappel vers le niveau haut est égale à ladite basse tension de rappel vers le niveau haut, et
      prendre une troisième valeur qui fait propager par lesdits multiplexeurs (20a, 20b) les sorties desdits troisièmes comparateurs (18a, 18b) si la valeur courante de la tension de rappel vers le niveau haut est égale à ladite haute tension de rappel vers le niveau haut.

3. Circuit d'interface I$^2$C (30) selon la revendication 1, dans lequel chacun desdits premier (24a) et deuxième (24b) étages comparateurs comprend :

   un premier comparateur (14a, 14b) dont le seuil bas ($V_{IL}$) est réglé sur ladite première valeur fractionnelle de ladite haute tension de rappel vers le niveau haut et dont le seuil haut ($V_{IH}$) est réglé sur ladite deuxième valeur fractionnelle de ladite basse tension de rappel vers le niveau haut ; et
   un deuxième comparateur (32a, 32b) pouvant être commuté au choix entre un premier mode de comparaison et un deuxième mode de comparaison en fonction de la valeur d'un premier registre programmable (36), dans lequel dans le premier mode de comparaison le seuil bas ($V_{IL}$) est réglé sur ladite première valeur fractionnelle de ladite basse tension de rappel vers le niveau haut et le seuil haut ($V_{IH}$) est réglé sur ladite deuxième valeur fractionnelle de ladite basse tension de rappel vers le niveau haut, et dans le deuxième mode de comparaison le seuil bas ($V_{IL}$) est réglé sur ladite première valeur fractionnelle de ladite haute tension de rappel vers le niveau haut et le seuil haut ($V_{IH}$) est réglé sur ladite deuxième valeur fractionnelle de ladite haute tension de rappel vers le niveau haut ; et

un multiplexeur (34a, 34b) configuré pour propager l'une des sorties desdits premier (14a, 14b) et deuxième (32a, 32b) comparateurs en fonction de la valeur d'un deuxième registre programmable (22) ;

dans lequel ledit deuxième registre programmable (22) est réglé par défaut sur une première valeur qui fait propager par lesdits multiplexeurs (34a, 34b) les sorties desdits premiers comparateurs (14a, 14b), et est programmable, en réponse à la réception de ladite trame de programmation, pour prendre une deuxième valeur qui fait propager par lesdits multiplexeurs (34a, 34b) les sorties desdits deuxièmes comparateurs (32a, 32b) ; et dans lequel ledit premier registre programmable (36) est programmable par ladite trame de programmation pour :

prendre une première valeur qui fait fonctionner les deuxièmes comparateurs (32a, 32b) dans le premier mode de comparaison, si la valeur courante de la tension de rappel vers le niveau haut est égale à ladite basse tension de rappel vers le niveau haut, et

prendre une deuxième valeur qui fait fonctionner les deuxièmes comparateurs (32a, 32b) dans le deuxième mode de comparaison, si la valeur courante de la tension de rappel vers le niveau haut est égale à ladite haute tension de rappel vers le niveau haut.

4.  Circuit d'interface I$^2$C (40) selon la revendication 1, dans lequel chacun desdits premier (24a) et deuxième (24b) étages comparateurs comprend un comparateur (42a, 42b) pouvant être commuté au choix entre un premier, un deuxième et un troisième mode de comparaison en fonction de la valeur d'un registre programmable (44), dans lequel :

dans le premier mode de comparaison, le seuil bas ($V_{IL}$) est réglé sur ladite première valeur fractionnelle de ladite haute tension de rappel vers le niveau haut et le seuil haut ($V_{IH}$) est réglé sur ladite deuxième valeur fractionnelle de ladite basse tension de rappel vers le niveau haut ;

dans le deuxième mode de comparaison, le seuil bas ($V_{IL}$) est réglé sur ladite première valeur fractionnelle de ladite basse tension de rappel vers le niveau haut et le seuil haut ($V_{IH}$) est réglé sur ladite deuxième valeur fractionnelle de ladite basse tension de rappel vers le niveau haut ; et

dans le troisième mode de comparaison, le seuil bas ($V_{IL}$) est réglé sur ladite première valeur fractionnelle de ladite haute tension de rappel vers le niveau haut et le seuil haut ($V_{IH}$) est réglé sur ladite deuxième valeur fractionnelle de ladite haute tension de rappel vers le niveau haut ;

dans lequel ledit registre programmable (44) est réglé par défaut sur une première valeur qui fait fonctionner lesdits comparateurs (42a, 42b) dans le premier mode de comparaison, et est programmable par ladite trame de programmation pour :

prendre une deuxième valeur qui fait fonctionner les comparateurs (42a, 42b) dans le deuxième mode de comparaison, si la valeur courante de la tension de rappel vers le niveau haut est égale à ladite basse tension de rappel vers le niveau haut, et

prendre une troisième valeur qui fait fonctionner les comparateurs (42a, 42b) dans le troisième mode de comparaison, si la valeur courante de la tension de rappel vers le niveau haut est égale à ladite haute tension de rappel vers le niveau haut.

5.  Circuit d'interface I$^2$C (10 ; 30 ; 40) selon l'une quelconque des revendications précédentes, dans lequel ladite basse tension de rappel vers le niveau haut est égale à 1,8 V environ et ladite haute tension de rappel vers le niveau haut est égale à 3,3 V environ.

6.  Circuit d'interface I$^2$C (10 ; 30 ; 40) selon l'une quelconque des revendications précédentes, dans lequel ladite première valeur fractionnelle est égale à 0,3 environ et ladite deuxième valeur fractionnelle est égale à 0,7 environ.

7.  Dispositif électronique comprenant :

un circuit d'interface I$^2$C (10 ; 30 ; 40) selon l'une quelconque des revendications précédentes ; et un circuit de traitement configuré pour :

recevoir, via le circuit d'interface I$^2$C, ladite trame de programmation qui porte la valeur courante de la tension de rappel vers le niveau haut ; et

faire commuter ledit premier étage comparateur (24a) et ledit deuxième étage comparateur (24b) du circuit d'interface I$^2$C (10 ; 30 ; 40) vers ledit deuxième mode de fonctionnement en fonction de ladite trame de programmation.

**8.** Procédé de mise en œuvre d'un circuit d'interface I$^2$C (10 ; 30 ; 40) selon l'une quelconque des revendications 1 à 6 ou un dispositif électronique selon la revendication 7, le procédé comprenant les étapes suivantes :

recevoir un signal d'horloge (*I2Cclk*) sur ladite première broche (12a) et recevoir un signal de données (*I2Cdata*) sur ladite deuxième broche (12b) ;

comparer le signal d'horloge reçu (*I2Cclk*) avec un seuil bas ($V_{IL}$) et un seuil haut ($V_{IH}$) dans ledit premier étage comparateur (24a) et produire un signal d'horloge interne (*clk_in*) ;

comparer le signal de données reçu (*I2Cdata*) avec ledit seuil bas ($V_{IL}$) et ledit seuil haut ($V_{IH}$) dans ledit deuxième étage comparateur (24b) et produire un signal de données interne (*data_in*) ;

programmer par défaut le premier étage comparateur (24a) et le deuxième étage comparateur (24b) pour fonctionner dans un premier mode de fonctionnement, dans lequel ledit seuil bas ($V_{IL}$) est réglé sur une première valeur fractionnelle de ladite haute tension de rappel vers le niveau haut et ledit seuil haut ($V_{IH}$) est réglé sur une deuxième valeur fractionnelle de ladite basse tension de rappel vers le niveau haut ; et

faire commuter, en fonction d'une trame de programmation reçue via l'interface I$^2$C qui porte une valeur courante de la tension de rappel vers le niveau haut, le premier étage comparateur (24a) et le deuxième étage comparateur (24b) vers un deuxième mode de fonctionnement, dans lequel ledit seuil bas ($V_{IL}$) est réglé sur ladite première valeur fractionnelle de la tension de rappel vers le niveau haut courante et ledit seuil haut ($V_{IH}$) est réglé sur ladite deuxième valeur fractionnelle de la tension de rappel vers le niveau haut courante.

FIG. 1

FIG. 2

EP 4 583 404 B1

FIG. 3

FIG. 4

EP 4 583 404 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10447269 B1
- CN 106844270 A
- CN 112650377 A
- WO 2020218472 A1
- CN 106788354 B
- US 5166550 A
- US 20070296478 A1

**Non-patent literature cited in the description**

- I2C-bus specification and user manual. User manual UM10204 by NXP. 01 October 2021
- TAS2764 Digital Input Mono Class-D Audio Amplifier With Speaker IV Sense. SLOS998A. December 2020
- TI Designs - Precision: Verified Design - Comparator with Hysteresis Reference Design. TIDU020A. Texas Instruments, May 2013
- Analog Engineer's Circuit - Programmable comparator circuit with hysteresis or latching output. SLAAE. Texas Instruments, 20 May 2021
- **Y. YAO** ; **M. JIANG**. Design of Hysteresis Comparator with Wide Common Mode Operating Range. *2022 IEEE 4th International Conference on Circuits and Systems (ICCS), Chengdu, China*, 2022, 91-94